# EUROPÄISCHE PATENTANMELDUNG

(11) **EP 1 286 393 A2**
(43) Veröffentlichungstag der Anmeldung: **26.02.2003**
(21) Anmeldenummer: 01115832.6
(22) Anmeldetag: 28.06.2001
(51) Int. Cl.: H01L 23/051, H01L 23/055, H01L 23/16, H01L 21/60

(54) **Schaltkreisgehäuse**

(71) Anmelder: F & K Delvotec Bondtechnik GmbH, 85521 Ottobrunn (DE)
(72) Erfinder: Farassat, Farhad, Dr., 82024 Taufkirchen (DE)
(74) Vertreter: Heinze, Ekkehard, Dipl.-Phys. Dr.

(57) **Zusammenfassung**

Miniaturisiertes Schaltkreisgehäuse zur Verkapselung und externen Kontaktierung mindestens eines integrierten Schaltkreises, insbesondere vom Flipchip- oder Wafer- Level-Package-Typ oder, mit einem Gehäuseboden, dessen Unterseite Gehäuse-Kontaktelemente zur externen Kontaktierung trägt und dessen Oberseite elektrisch mit Schaltkreis-Kontaktelementen an der Unterseite des Schaltkreises verbunden ist, wodurch ein dem Gehäuseboden insbesondere gegenüberliegender Gehäusedeckel vorgesehen ist, welcher den Schaltkreis mit den Schaltkreis-Kontaktelementen federnd gegen die Oberseite des Gehäusebodens andrückt und keine stoffschlüssige Verbindung zwischen den Schaltkreis-Kontaktelementen und dem Gehäuseboden besteht.

## Beschreibung

Die Erfindung betrifft ein miniaturisiertes Schaltkreisgehäuse nach dem Oberbegriff des Anspruchs 1.

Integrierte Schaltkreise (Chips) werden in elektronischen Geräten nahezu ausschließlich in Gehäuse montiert eingesetzt. Diese Gehäuse schützen die empfindlichen Halbleiterstrukturen vor schädlichen Umwelteinflüssen wie Feuchtigkeit, Licht, Staub und Krafteinwirkungen. Vielfach wird mit der Montage in Gehäuse zugleich eine Anpassung der Strukurbreiten und -abstände der LSI- und VLSI-Halbleitertechnologie an die - teilweise wesentlich größeren - Strukturabmessungen der Leiterplattentechnologie angepaßt.

Die physikalischen Eigenschaften ihrer Gehäuse beeinflussen das elektrische Verhalten und die Zuverlässigkeit der Chips in erheblichen Maße, und die Montage- und Gehäusetechnik stellt eine wesentliche, die Leistungsparameter und Kosten mitbestimmende Komponente des Gesamtprozesses der Herstellung von Halbleiterbauelementen dar.

Im Laufe der Entwicklung der Halbleitertechnologie wurden verschiedene Gehäusetypen mit unzähligen Varianten entwickelt. Unter dem Blickwinkel der Montierbarkeit auf einer Leiterplatte (Platine) unterscheidet man insbesondere steckmontierbare und oberflächenmontierbare Gehäuse, und mit Blick auf die Technik der Verbindung des Chips mit den äußeren Anschlüssen des Gehäuses insbesondere das Drahtbond-Verfahren und das Flipchip-Verfahren.

Im Zuge der immer weiter fortschreitenden Miniaturisierung hochleistungsfähiger elektronischer Geräte und ihrer Komponenten, werden seit einigen Jahren miniaturisierte Schaltkreisgehäuse realisiert, deren Abmessungen nur unwesentlich größer als diejenigen des im Gehäuse untergebrachten Chips sind und die daher im allgemein hin als Chip-Scale-Packages (CSP) bezeichnet werden. Nennenswerte Marktanteile haben auch bereits Gehäuseausführungen gefunden, welche direkt auf dem - noch ungeteilten - Wafer ausgeführt und daher als Wafer-Level-Packages (WLP) bezeichnet werden. Als Verbindungstechnik kommt hier üblicherweise eine modifizierte Flipchip-Technik zum Einsatz, bei der Kontaktflächen des Flips einerseits und des Gehäuses bzw. der Platine andererseits (die sogenannten Pads) ohne Draht über Lötpunkte (als Bumps oder - wegen ihrer meist kugelähnlichen Form - auch als Solder Balls bezeichnet) miteinander verbunden werden.

Die erwähnten miniaturisierten Gehäuse, speziell die WLP, werden bereits für eine Vielzahl verschiedenartiger Produkte eingesetzt, insbesondere für serielle EEPROMs, Flash-Speicher, integrierte passive Bauelementkonfigurationen (IPD) sowie analoge, HF- und Leistungsschaltkreise. Begonnen wurde auch mit dem Packaging von DRAMs mit diesen Techniken. Unter dem Begriff "Schaltkreis" ist daher nachfolgend jede beliebige integrierte elektronische Bauelementkonfiguration zu verstehen, die mit einem miniaturisierten Gehäuse der oben erwähnten Art versehen werden kann.

Die Gehäuse der in Rede stehen Art bestehen im wesentlichen aus Kunststoff oder Keramik und sind in der Regel hermetisch verschlossen. Keramikgehäuse werden nach Chipbefestigung und Herstellung der Bondverbindungen mit einem aufgepressten Keramik- oder aufgelöteten Metalldeckel versehen, und ein Glaslot (Sealing Glass) stellt eine dichte Verbindung zwischen Deckel und Gehäusewandung her. Zur Fertigstellung eines Kunststoffgehäuses werden die noch zusammenhängenden Chipträger (Laedframes), auf denen bis zu 100 Schaltkreise in Streifenform angeordnet sind, mit mineralisch gefülltem Epoxidharz bei hoher Temperatur umpreßt.

Der Einsatz verschiedenartiger Materialien mit sehr unterschiedlichen thermischen Ausdehnungskoeffizienten auf kleinstem Raum führt zu verschiedenen Zuverlässigkeitsproblemen. Als hartnäckig problematisch erweisen sich Risse und Brüche in den Lötverbindungen zwischen den Kontaktflächen der Chips und Gehäuse, also den oben erwähnten Bumps. Man hat versucht, deren mechanische Stabilität dadurch zu erhöhen, daß man sie - in technologisch höchst aufwendiger Weise - mit einem Polymer- "kragen" umgibt. Diese und ähnliche Entwicklungen haben aber keinen durchgreifenden Erfolg gebracht. Auch die Chips selbst haben sich als bruchgefährdet erwiesen; erhebliche Gefahren für die Zuverlässigkeit im Langzeitbetrieb gehen insbesondere von feinen Rissen (Microcracks) aus.

Der Erfindung liegt daher die Aufgabe zugrunde, ein verbessertes Schaltkreisgehäuse der gattungsgemäßen Art anzugeben, welches eine wesentliche Erhöhung der Zuverlässigkeit der Einheitchip-Gehäuse ohne einschneidende Kostenerhöhung erbringt.

Diese Aufgabe wird durch ein miniaturisiertes Schaltkreisgehäuse mit den Merkmalen des Anspruches 1 gelöst.

Die Erfindung beruht auf der Erkenntnis des Erfinders, daß die seit Jahren in der Fachliteratur diskutierten und durch die verschiedenartigen früheren Lösungsvorschläge bisher nicht behobenen Zuverlässigkeitsprobleme der bekannten miniaturisierten Schaltkreisgehäuse, insbesondere der Gehäuse vom Flipchip- oder WLP-Typ, im Grunde durch das Prinzip der stoffschlüssigen Verbindung von Materialien mit sehr unterschiedlichen thermischen Ausdehnungskoeffizienten bedingt sind. Sie schließt weiter den Gedanken einer grundlegenden Abkehr von der bisher durchgängig praktizierten stoffschlüssigen Verbindung (Lötverbindung) ein.

Schließlich umfaßt die Erfindung den Gedanken, einen hinreichend niedrigen Übergangswiderstand zwischen Chip-Kontaktelementen und Gehäuse-Kontaktflächen durch einen elastischen Andruck zwischen beiden mit hinreichender, auf die konkrete Ausbildung (Form und Material) der Chip-Kontaktelemente abgestimmte Anpresskraft zu realisieren. (Dieses Prinzip wird natürlich auch in einer Variante zum Tragen gebracht, bei der sich die Kontaktelemente am Gehäuse und mit ihnen in elektrischem Kontakt stehende Kontaktflächen am Chip befinden).

Unter dem Begriff "Kontaktflächen" werden im Kontext der Erfindung sowohl echte Flächenkontakte (Pads) verstanden als auch - in einer möglicherweise sogar bevorzugten Ausführung - flache Erhebungen aus einem gut leitfähigen und korosionsbeständigen Material, insbesondere Gold.
Solche flachen Erhebungen können insbesondere durch Stempeln ("Platt drücken") von kleinen Goldkugeln ähnlich den üblichen Bumps gebildet werden. Diese Auführung gewährleistet eine höhere Zuverlässigkeit der Chip-Kontaktierung innerhalb des Gehäuses im Hinblick auf höheren Toleranzen der Bumps bzw. geringfügige Krümmungen oder Verwerfungen der Gehäuse- bzw. Chipoberflächen.

Ein wesentlicher Vorteil der vorgeschlagenen Lösung besteht darin, daß der Chip nicht am Gehäuse angelötet oder eutektisch mit dessen Kontaktflächen bzw. -elementen verbunden werden muß, wodurch ein technologisch aufwendiger Arbeitsgang eingespart wird. Infolge des Fehlens einer stoffschlüssigen (und damit starren) Verbindung zwischen Chip und Gehäuse treten die derzeitigen, auf unterschiedliche Wärmeausdehnugskoefizienten zurückzuführenden Qualitätsprobleme praktisch nicht mehr auf. Zudem kann das Gehäuse sofort getestet (und dann erst geschlossen bzw. gefertigt) werden, und Reparaturen sind - ohne Verschrottung des teueren Chips - in kostengünstiger Weise möglich.

In einer ersten bevorzugten Ausführung hat der Gehäusedeckel des Chipgehäuses auf der dem Chip zugewandten Unterseite mindestens ein den Chip gegen den Gehäuseboden vorspannendes Federelement. Dieses ist bevorzugt fest an der Unterseite des Gehäusedeckels angebracht, in einer alternativen Ausführung ist jedoch mindestens ein lose zwischen Gehäusedeckel und Chip eingelegtes Federelement vorgesehen, und schließlich kann das Federelement grundsätzlich auch auf der Oberfläche des Chips angebracht (beispielsweise aufgeklebt) sein.

Das Federelement ist beispielsweise als federnder Metallstreifen in Art einer Kontakt- oder Blattfeder, federnder Metallring oder Drahtbügel ausgeführt; vergleichbare geometrische Ausformungen sind auch mit Kunststoff möglich. Daneben ist der Einsatz von - separat vom Deckel gefertigten - Elastomerschaumelementen möglich.

In einer weiteren Ausführungsform ist der Gehäusedeckel selbst zur Bereitstellung der elastischen Anpresskraft für den Chip ausgebildet - beispielsweise durch eine Formgebung, die eine entsprechende Formelastizität bewirkt und/oder durch eine kompressible Ausführung oder zumindest das Vorsehen kompressibler Bereiche (beispielsweise aus einem Elastomearschaum).

In einer weiteren bevorzugten Ausführung hat das vorgeschlagene Gehäuse eine den Gehäuseboden am Umfang mit dem Gehäusedeckel (im fertigen Zustand des Gehäuses) im wesentlichen starr miteinander verbindende und das Gehäuseinnere dicht abschließende Wandung. Die Wandung kann zum einen an den Gehäuseboden und zum anderen an den Gehäusedeckel - insbesondere einstückig - angeformt sein und ist dann gegenüber dem jeweils anderen Gehäuseteil bevorzugt gasdicht versiegelt. In einer modifizierten Ausführung ist auch eine derart gekrümmte Ausführung des Gehäusedeckels möglich, daß es keine vom Deckel unterscheidbare Umfangswandung gibt.

Die Versiegelung zwischen der Wandung und dem Gehäuseboden bzw. dem Gehäusedeckel (oder - in der letztgenannten Variante - direkt zwischen Boden und Deckel) kann durch eine äußere Kunststoffverkapselung mindestens der Stoßfuge zwischen den angrenzenden Teilen gebildet sein oder eine solche Kunststoffversiegelung jedenfalls umfassen. Bei Keramikgehäusen kann die Versiegelung (in an sich bekannter Weise) auch durch ein Glaslot gebildet sein.

Die erwähnte gasdichte Versiegelung ermöglicht in vorteilhafter Weise eine dauerhafte Ausfüllung des Gehäuseinnenraumes mit einem reaktionsträgen Medium, insbesondere einem Inertgas, welches etwaige Korrosionsvorgänge im Gehäuseinneren zuverlässig ausschließt.

In Anlehnung an übliche Gehäuseformen ist aus derzeitiger Sicht eine flach quaderförmige Gestaltung des vorgeschlagenen Gehäuses mit im wesentlichen ebenem und rechteckigem Gehäuseboden und Gehäusedeckel bevorzugt. Mit der oben erwähnten gekrümmten Deckelausführung würde sich beispielsweise eine flach zylinderabschnittförmige, kugelabschnittförmige oder tonnenförmige Gehäuseausführung ergeben. Es versteht sich jedoch, daß im Rahmen der Erfindung auch andere Gehäuseformen realisierbar sind.

Zur Vermeidung einer Übertragung von äußeren Krafteinwirkungen auf den Chip ist der Gehäusedeckel bevorzugt derart starr ausgebildet und gegebenenfalls mit der Wandung verbunden, daß äußere Kräfte zuverlässig abgefangen werden. Die gleiche Funktion kann ein Überfang mit einer starren Abdeckung (beispielsweise aus einem ausgehärteten gefüllten Kunstharz) haben.

In einer weiter bevorzugten Ausführung ist der Gehäusedeckel als Wärmesenke zur Kühlung des Schaltkreises ausgebildet und weist hierfür insbesondere Kühlrippen oder dergleichen flächenvergrößernde Anformungen aus. Bei dieser Ausführung ist die Herstellung des Deckels selbst sowie auch des Federelementes oder der Federelemente aus gut wärmeleitendem Material bevorzugt, um einen effizienten Wärmeübergang vom Chip auf die Kühlrippen o.ä. zu gewährleisten.

Der Gehäuseboden kann in einer insbesondere für miniaturisierte elektronische Geräte sinnvollen Ausführung zugleich als Platine des Gerätes oder Abschnitt einer solchen ausgebildet sein.

Bei den Gehäuse-Kontaktelementen handelt es sich in einer ersten zweckmäßigen, auf die heutigen Montagetechnologien elektronischer Geräte abgestimmten Ausführung um im wesentlichen kugel- bzw. kugelabschnittsförmig ausgeführte Elemente ("Bumps") in Art von Lotkugeln. In einer weiteren Ausführung sind die Kontaktelemente des Gehäuses in Stiftform und in einer noch anderen Ausführung als Kontaktflächen ausgebildet. Die konkrete Ausführung richtet sich nach den in der Gerätefertigung, bei der das vorgeschlagene Gehäuse eingesetzt wird, angewandten Entwurfsprinzipien und Montageverfahren.

Im Sinne der oben erwähnten Abstimmung zwischen Material und Form der Chip-Kontaktelemente auf die elastische Anpresskraft des Deckels eignet sich als Material für die Chip-Kontaktelemente besonders Gold oder eine nicht zu harte Goldlegierung - jedoch ist auch der Einsatz anderer Edelmetalle, die hinsichtlich der Härte und des Fließverhaltens den bestehenden Anforderungen dauerhaft gerecht werden, möglich.

Vorteile und Zweckmäßigkeiten der Erfindung ergeben sich im übrigen aus den Unteransprüchen sowie der nachfolgenden Beschreibung von Ausbildungsbeispielen anhand der Figuren. Diese zeigen:
- Fig. 1A bis 1C: Prinzipskizzen eines mit einem erfindungsgemäßen Gehäuse zu verkapselnden Halbleiterchips in perspektivischen Darstellungen (Fig. 1A und 1B) bzw. einer Querschnittsdarstellung (Fig. 1C),
- Fig. 2A bis 2C: Prinzipsskizzen eines ersten, einen Gehäuseboden und eine angeformte Wandung umfassenden Gehäuseteils eines Schaltkreisgehäuses in perspektivischer Darstellung (Fig. 2A) bzw. Seitenansicht (Fig. 2B) einer ersten Ausführung sowie als Querschnittsdarstellung einer zweiten Ausführung (Fig. 2C),
- Fig. 3A und 3B: eine perspektivische schematische Darstellung bzw. eine Seitenansicht eines Gehäusedeckels als zweites Teil eines Schaltkreisgehäuses,
- Fig. 4: eine schematische Querschnittsdarstellung eines aus einem Halbleiterchip gemäß Fig. 1A bis 1C, einem Boden- Wandungsteil nach Fig. 2A und 2B und einem Gehäusedeckel nach Fig. 3A und 3B zusammengesetzten Schaltkreisgehäuses,
- Fig. 5A bis 5C: Darstellungen der Teile einer weiteren Schaltkreis-Gehäuseausführung in Querschnittsdarstellungen bzw. Seitenansichten,
- Fig. 6 und 7: skizzenartige Darstellungen der Gehäusedeckel und Federelemente gemäß weiteren Ausführungsformen der Erfindung und
- Fig. 8: eine schematische perspektivische Darstellung einer Gesamtanordnung aus Schaltkreisgehäuse und IC gemäß einer weiteren Ausführungsform.

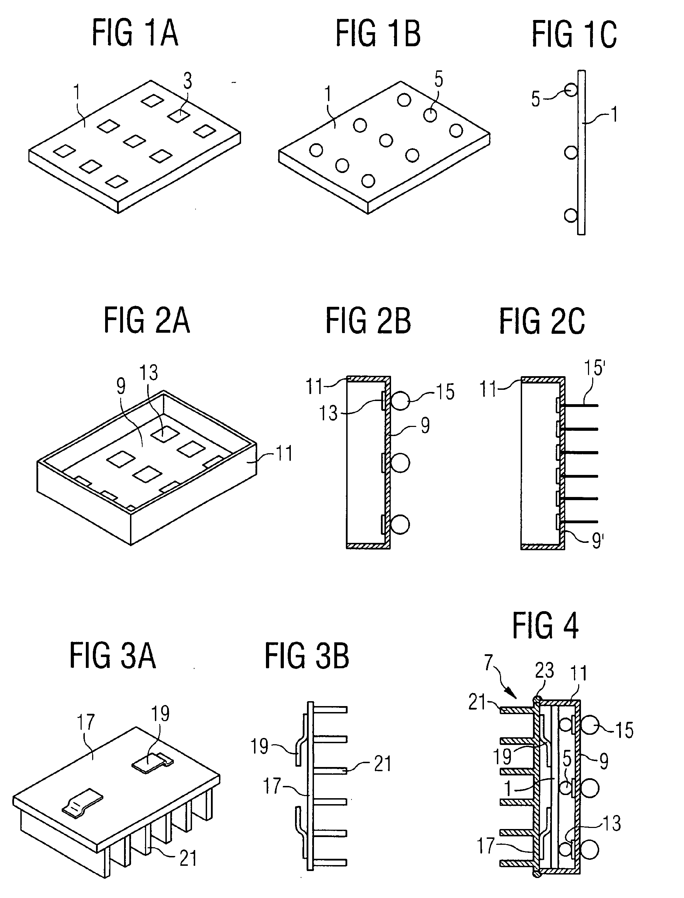

Die Figuren 1A bis 4 zeigen - in grob schematischen Darstellungen - einen Halbleiterchip 1 mit metallischen Kontaktflächen 3 und Gold-Kontaktelementen (Bumps) 5 zur Verkapselung in einem miniaturisierten Chipgehäuse 7. Dieses hat einen - entsprechend der rechteckigen Grundform des Chips - rechteckigen Gehäuseboden 9 mit einstückig angeformter, flacher Wandung 11, auf dessen Innenseite ebenfalls metallische Kontaktflächen 13 vorgesehen sind und der auf seiner Unterseite (Außenseite) Löt-Kontaktelemente (Solder Balls) 15 bzw. - in der modifizierten Ausführung nach Fig. 2C - Kontaktstifte 15' als Gehäuse-Kontaktelemente hat. (Da in der Ausführung nach Fig. 2C natürlich auch der Gehäuseboden entsprechend modifiziert ist, ist er dort mit der Bezugsziffer 9' gekennzeichnet.) Weiterhin hat das Gehäuse 7 einen Gehäusedeckel 17, der ebenso flach rechteckig ausgebildet ist wie der Gehäuseboden 9 und im mittleren Bereich zwei metallische Federelemente (Blattfedern) 19 auf seiner Unterseite und Kühlrippen 21 auf seiner Oberseite trägt.

In Fig. 4 ist das Gehäuse 7 im montierten Zustand gezeichnet. Es ist zu erkennen, daß der Chip 1 derart auf den Gehäuseboden 9 mit der Umfangswandlung 11 aufgesetzt ist, daß die Bumps 5 auf der Innenseite des Gehäusebodens (und zwar dort auf den Kontaktflächen 13) auflegen. Auf die Oberseite des Chips 1 ist der Gehäusedeckel 17 derart aufgesetzt, daß die Federelemente 19 der Chip-Oberseite zugewandt sind und elastischen Druck auf diese ausüben, der auf die Bumps 5 übertragen wird und diese gegen die Kontaktflächen am Gehäuseboden 9 andrückt. Zugleich dienen die metallischen Federelemente 19 zur Wärmeübertragung vom Chip auf den Gehäusedeckel 17 und über diesen auf die Kühlrippen 21, die in dieser Ausführung - ebenso wie der Deckel 17 selbst - aus gut wärmeleitfähigen Material bestehen.

Das Gehäuseinnere ist bevorzugt mit einem Inertgas (insbesondere Argon oder Stickstoff) gefüllt, was durch eine Gehäusemontage in Inertgasatmosphäre relativ leicht realisiert werden kann. Schließlich ist die Stoßfuge zwischen dem Umfangsrand des Gehäusedeckels 17 und dem Umfangsrand der Wandung 11 mit einer auf das Gehäusematerial geeignet abgestimmten Versiegelung 23 (Glaslot oder Kunstharzkleber o.ä.) hermetisch versiegelt.

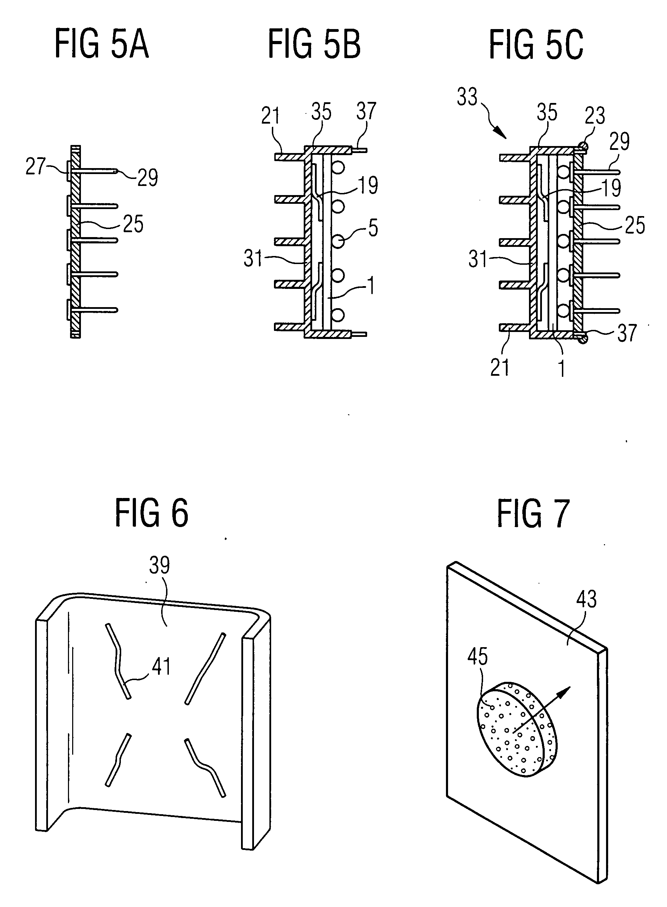

In Fig. 5A bis 5C ist eine weitere Ausführungsform skizziert, bei der der in Fig. 1A bis 1C dargestellte Chip 1 in ein Gehäuse eingeschlossen wird, dessen Boden durch eine Platine 25 mit Kontaktflächen 27 und mit diesen verbundenen Kontaktstiften 29 zur externen Kontaktierung gebildet ist. In Verbindung mit dieser Platine 27 wird ein modifizierter Gehäusedeckel 31 zur Bildung eines Chipgehäuses 33 eingesetzt, der eine einstückig angeformte Wandung 35 und an dieser Zentrierpins 37 zur Zentrierung von Gehäusedeckel und eingelegtem Chip gegenüber der Platine hat. (Die hier nicht genannten Teile sind dieselben wie in der vorgenannten Ausführung und tragen auch dieselben Bezugsziffern wie in den Figuren 1A bis 4.)

In Fig. 6 und 7 sind zwei weitere Ausführungsformen von Gehäusedeckel und Federelement(en) zur Verkapselung des Chips unter gleichzeitiger Erzeugung einer elastischen Andruckkraft seiner Kontaktelemente an einen Gehäuseboden in perspektivischen Darstellungen gezeigt. Fig. 6 zeigt einen Gehäusedeckel 39 in der Grundform eines "U", auf dessen Unterseite vier gebogene Federdrähte 41 als Kontaktelemente angebracht (beispielsweise angeklebt oder angelötet) sind, die ähnlich wie die Blattfedern 19 bei der ersten Ausführungsform wirken.

Bei der Ausführung nach Fig. 7 ist der Gehäusedeckel 43 einfach eine rechteckige Platte, unter die - was durch den Pfeil in der Figur symbolisiert wird - beim Aufdrücken des Deckels auf das Gehäuseunterteil (Gehäuseboden und Wandung) ein im Querschnitt eleptisches, separat gefertigtes Federelement 45 aus einem Elastomerschaum eingelegt wird.

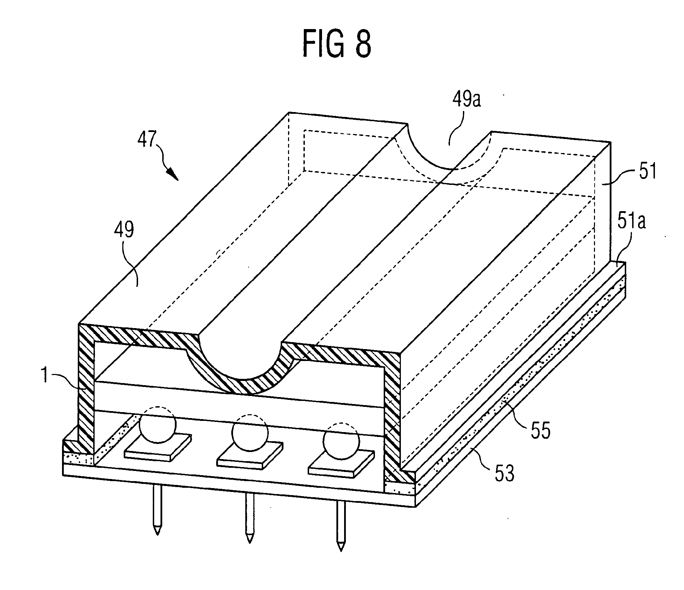

In Fig. 8 schließlich ist ein Chipgehäuse 47 in einer Außenansicht skizziert, welches - wie auch die Gehäuse nach Fig. 4 und 5C - eine annähernd flach quaderförmige Grundform hat. Dessen Kunststoffgehäusedeckel 49 mit integral angeformter Wandung 51 und Montageflansch 51a hat einen halb zylindrischen nach innen gewölbten Mittenbereich 49a hat. Dieser Mittenbereich 49a hat eine geringere Wandungsstärke als der übrige Gehäusedeckel 49 und dadurch eine gewissen Formelastizität und preßt auf die Oberseite des eingesetzten Chips und drückt diesen damit gegen die Innenseite des Gehäusebodens 53 elastisch an. Zwischen dem Montagegeflansch 51a und dem Gehäuseboden 50 befindet sich eine umlaufende Versiegelung 55 aus einem Schnellkleber.

Ein in sich federnder Gehäusedeckel kann auch auf vielerlei anderer Art ausgeführt werden, so beispielsweise als gebogenes Federblech. Bei derartigen Ausführungen ist im Normalfall ein zusätzlicher Schutzdeckel (beispielsweise aus Kunststoff) zur Verhinderung von Beschädigungen des Chips bei äußerer Krafteinwirkung auf das Gehäuse vorzusehen.

Die Ausführung der Erfindung ist nicht auf die oben beschriebenen Beispiele und hervorgehobenen Aspekte beschränkt, sondern ebenso in einer Vielzahl von Abwandlungen möglich, die - in Anpassung an die jeweilige Spezifik des anzuwendenen Montageverfahrens und Gehäusematerials sowie einer vorgegebenen Gehäuse-Grundform - im fachgemäßen Ermessen liegen.

### Bezugszeichenliste

- 1: Halbleiterring
- 3; 13; 27: Kontaktfläche
- 5: Gold-Kontaktelement (Bump)
- 7; 33; 47: Chipgehäuse
- 9; 9'; 53: Gehäuseboden
- 11; 35; 51: Wandung
- 15: Löt-Kontaktelement (Solder Ball)
- 15'; 29: Kontaktstift
- 17; 31; 39; 43; 49: Gehäusedeckel
- 19: Federelement (Blattfeder)
- 21: Kühlrippe
- 23; 55: Versiegelung
- 25: Platine
- 37: Zentrierpins
- 41: Federdraht
- 45: Elastomerschaum-Federelement
- 51a: Montageflansch

## Patentansprüche

1. Miniaturisiertes Schaltkreisgehäuse zur Verkapselung und externen Kontaktierung mindestens eines integrierten Schaltkreises, insbesondere vom Flipchip- oder Wafer-Level-Package-Typ oder, mit einem Gehäuseboden, dessen Unterseite Gehäuse-Kontaktelemente zur externen Kontaktierung trägt und dessen Oberseite elektrisch mit Schaltkreis-Kontaktelementen an der Unterseite des Schaltkreises verbunden ist,
**dadurch gekennzeichnet, daß**
ein dem Gehäuseboden insbesondere gegenüberliegender Gehäusedeckel vorgesehen ist, welcher den Schaltkreis mit den Schaltkreis-Kontaktelementen federnd gegen die Oberseite des Gehäusebodens andrückt und keine stoffschlüssige Verbindung zwischen den Schaltkreis-Kontaktelementen und dem Gehäuseboden besteht.

2. Schaltkreisgehäuse nach Anspruch 1,
**dadurch gekennzeichnet, daß**
der Gehäusedeckel auf der dem Schaltkreis zugewandten Unterseite mindestens ein den Schaltkreis gegen den Gehäuseboden vorspannendes Federelement aufweist.

3. Schaltkreisgehäuse nach Anspruch 2,
**dadurch gekennzeichnet, daß**
das Federelement oder die Federelemente fest an der Unterseite des Gehäusedeckels angebracht sind.

4. Schaltkreisgehäuse nach Anspruch 2,
**dadurch gekennzeichnet, daß**
das Federelement oder die Federelemente lose zwischen Gehäusedeckel und Schaltkreis eingelegt sind.

5. Schaltkreisgehäuse nach einem der vorangehenden Ansprüche,
**dadurch gekennzeichnet, daß**
das der Gehäusedeckel selbst federelastisch ausgebildet ist.

6. Schaltkreisgehäuse nach einem der vorangehenden Ansprüche,
**gekennzeichnet durch**
eine Gehäuseboden und Gehäusedeckel am Umfang im wesentlichen starr miteinander verbindende und das Gehäuseinnere dicht abschließende Wandung.

7. Schaltkreisgehäuse nach Anspruch 6,
**dadurch gekennzeichnet, daß**
das die Wandung an den Gehäuseboden oder Gehäusedeckel, insbesondere einstückig, angeformt und gegenüber dem jeweils anderem Gehäuseteil gasdicht versiegelt ist.

8. Schaltkreisgehäuse nach Anspruch 7,
**dadurch gekennzeichnet, daß**
die Versiegelung durch eine äußere Kunststoffverkapselung mindestens der Stoßfuge zwischen Gehäusedeckel oder Gehäuseboden und Wandung gebildet ist.

9. Schaltkreisgehäuse nach einem der vorangehenden Ansprüche,
**gekennzeichnet durch**
die Ausfüllung mit einem reaktionsträgen Medium, insbesondere einem Inertgas.

10. Schaltkreisgehäuse nach einem der vorangehenden Ansprüche,
**gekennzeichnet durch**
eine flache Quaderform mit im wesentlichen ebenem und rechteckigem Gehäuseboden und Gehäusedeckel.

11. Schaltkreisgehäuse nach einem der vorangehenden Ansprüche,
**dadurch gekennzeichnet, daß**
der Gehäusedeckel derart starr ausgebildet und mit der Wandung verbunden oder mit einer starren Abdeckung überfangen ist, daß eine äußere Krafteinwirkung nicht auf den Schaltkreis übertragen wird.

12. Schaltkreisgehäuse nach einem der vorangehenden Ansprüche,
**dadurch gekennzeichnet, daß**
der Gehäusedeckel als Wärmesenke zur Kühlung des Schaltkreises ausgebildet ist, insbesondere Kühlrippen oder dergleichen flächenvergrößernde Anformungen trägt.

13. Schaltkreisgehäuse nach einem der vorangehenden Ansprüche,
**gekennzeichnet durch**
eine derartige Ausbildung des Gehäusedeckels und/oder des Federelementes oder der Federelemente, daß die **durch** diese ausgeübte Andruckkraft zwischen dem Schaltkreis und dem Gehäuseboden zur Erhaltung eines dauerhaft guten elektrischen Kontaktes zwischen den Schaltkreis-Kontaktelementen und dem Gehäuseboden auf das Material der Schaltkreis-Kontaktelemente, insbesondere dessen Fließverhalten und deren Form, angestimmt ist.

14. Schaltkreisgehäuse nach einem der vorangehenden Ansprüche,
**dadurch gekennzeichnet, daß**
die Gehäuse-Kontaktelemente in Art von Lotkugeln im wesentlichen kugel- bzw. kugelabschnittsförmig gebildet sind.

15. Schaltkreisgehäuse nach einem der Ansprüche 1 bis 13,
**dadurch gekennzeichnet, daß**
die Gehäuse-Kontaktelemente im wesentlichen als Kontaktstifte oder Kontaktflächen ausgebildet sind.

16. Schaltkreisgehäuse nach einem der vorangehenden Ansprüche,
**dadurch gekennzeichnet, daß**
der Gehäuseboden als Platine oder Abschnitt einer solchen ausgebildet ist.

17. Schaltkreisgehäuse nach einem der vorangehenden Ansprüche,
**dadurch gekennzeichnet, daß**
an der Oberseite des Gehäusebodens zur internen Kontaktierung der Schaltkreis-Kontaktelemente innere Gehäuse-Kontaktflächen vorgesehen sind, welche insbesondere als flache Erhebung ausgebildet sind.

18. Schaltkreisgehäuse nach Anspruch 17,
**dadurch gekennzeichnet, daß**
die inneren Gehäuse-Kontaktflächen im wesentlichen aus Gold oder einer Goldlegierung bestehen und insbesondere durch Stempeln vom Bumps gebildet sind.

19. Schaltkreisanordnung mit einem elektronischen Schaltkreis, insbesondere vom Flipchip-Typ,und einem Schaltkreisgehäuse nach einem der vorangehenden Ansprüche,
**dadurch gekennzeichnet, daß**
die Schaltkreis-Kontaktelemente in Art von Bumps ausgebildet sind und im wesentlichen aus Gold oder einer Goldlegierung bestehen.
